# EUROPEAN PATENT APPLICATION

(11) **EP 4 701 089 A1**
(43) Date of publication of application: **25.02.2026**
(21) Application number: 25196684.2
(22) Date of filing: 19.08.2025
(51) Int. Cl.: H04B 5/48, H03F 3/72

(54) **NEAR FIELD COMMUNICATION CHIP, NEAR FIELD COMMUNICATION APPARATUS, ELECTRONIC DEVICE, AND METHOD FOR CONTROLLING NEAR FIELD COMMUNICATION**

(30) Priority: 19.08.2024 CN 202411143261
(71) Applicant: Shenzhen Goodix Technology Co., Ltd., Shenzhen, Guangdong 518045 (CN)
(72) Inventor: LIU, Shiyu, Shenzhen, 518045 (CN); LI, Shuaifei, Shenzhen, 518045 (CN)
(74) Representative: Kraus & Lederer PartGmbB

(57) **Abstract**

A near field communication chip, an apparatus, an electronic device and a method are provided. The chip includes a power amplifier module and a transmission control module. The power amplifier module comprises a ground resistor and a control switch. One end of the control switch is connected to the transmission end, the other end of the control switch is connected to the ground resistor, the control switch controls the transmission end to be connected to the ground resistor or be floating based on a control signal. When a received voltage at the receive end is greater than or equal to a first threshold, the near chip transitions from a low-power mode to a high-power mode. The transmission control module transmits the control signal to control the transmission end to be connected to the ground resistor, and the first threshold is set based on receive sensitivity of the receive end.

## Description

### TECHNICAL FIELD

Embodiments of the present disclosure relate to the field of near field communication, and particularly relate to a near field communication chip, a near field communication apparatus, an electronic device, and a method for controlling near field communication.

### BACKGROUND

An ordinary near field communication (NFC) apparatus comprises an antenna, a matching network, and a near field communication chip. Performance consistency refers to the fact that even when same antenna, matching network, and near field communication chip are used, deviations in consistency of the devices themselves will lead to differences in near field communication performance among different near field communication apparatuses. For example, deviations in antenna parameters, deviations in matching network device values, and deviations in near field communication chip manufacturing will all lead to differences in near field communication performance among different near field communication apparatuses. Too poor consistency in near field communication performance will lead to too large performance differences among different near field communication apparatuses, thereby resulting in poor user experience. In order to improve the performance consistency among near field communication apparatuses, near field communication apparatuses with poor performance can be removed by screening, but this will further result in low yield.

Therefore, how to improve the consistency of near field communication apparatuses has become a technical problem to be urgently solved.

### SUMMARY

In view of this, embodiments of the present disclosure provide a near field communication chip, a near field communication apparatus, an electronic device, and a method for controlling near field communication, thereby improving the consistency of the near field communication apparatus.

According to an embodiment in a first aspect of the present disclosure, a near field communication chip for use in a near field communication apparatus serving as a card emulator is provided, comprising: a transmission end, a receive end, a power amplifier module, and a transmission control module, wherein the power amplifier module is connected between the transmission end and the transmission control module; the power amplifier module comprises a ground resistor and a control switch, wherein one end of the control switch is connected to the transmission end, the other end of the control switch is connected to the ground resistor, the control switch is configured to control the transmission end to be connected to the ground resistor or be floating based on a control signal transmitted from the transmission control module, and a resistance value of the ground resistor is greater than or equal to 0.1 ohms and less than or equal to 10 ohms; and when a received voltage at the receive end is greater than or equal to a first threshold, the near field communication chip is configured to transition from a low-power mode to a high-power mode, the transmission control module transmits the control signal to control the transmission end to be connected to the ground resistor, and the first threshold is set based on receive sensitivity of the receive end.

According to an embodiment in a second aspect of the present disclosure, a near field communication antenna apparatus is provided, comprising the near field communication chip according to the first aspect, a matching network, and a near field communication antenna, wherein one end of the matching network is connected to the near field communication chip, and the other end of the matching network is connected to the near field communication antenna.

According to an embodiment in a third aspect of the present disclosure, a near field communication electronic device is provided, comprising the near field communication chip in the first aspect, a matching network, and a near field communication antenna, wherein one end of the matching network is connected to the near field communication chip, and the other end of the matching network is connected to the near field communication antenna.

According to an embodiment in a fourth aspect of the present disclosure, a method for controlling near field communication for use in a near field communication apparatus serving as a card emulator is provided, a near field communication chip comprising: a transmission end, a receive end, a power amplifier module, and a transmission control module, wherein the power amplifier module is connected between the transmission end and the transmission control module; the power amplifier module comprises a ground resistor and a control switch, one end of the control switch is connected to the transmission end, the other end of the control switch is connected to the ground resistor, the control switch is configured to control the transmission end to be connected to the ground resistor or be floating based on a control signal transmitted from the transmission control module, and a resistance value of the ground resistor is greater than or equal to 0.1 ohms and less than or equal to 10 ohms; and the control method comprising: detecting whether a received voltage at the receive end is greater than or equal to a first threshold; and switching, in response to the received voltage at the receive end being greater than the first threshold, the near field communication chip from a low-power mode to a high-power mode, transmitting, via the transmission control module, the control signal to control the transmission end to be connected to the ground resistor, and setting the first threshold based on receive sensitivity of the receive end.

In response to the received voltage at the receive ends being less than the first threshold, the near field communication chip is configured to return to the low-power mode in which the near field communication chip is configured to continuously detect whether the received voltage at the receive ends is greater than or equal to the first threshold. Or, in response to the received voltage at the receive ends being less than the fourth threshold, the near field communication chip is configured to return to the low-power mode in which the near field communication chip is configured to continuously detect whether the received voltage at the receive ends is greater than or equal to the fourth threshold, the fourth threshold is greater than or equal to the first threshold.

According to the near field communication chip, the near field communication apparatus, the electronic device, and the method for controlling near field communication provided in the embodiments of the present disclosure, the near field communication chip comprises: a transmission end, a receive end, a power amplifier module, and a transmission control module, wherein the power amplifier module is connected between the transmission end and the transmission control module. The power amplifier module comprises a ground resistor and a control switch, and a resistance value of the ground resistor is greater than or equal to 0.1 ohms and less than or equal to 10 ohms. When a received voltage at the receive end is greater than or equal to a first threshold, the near field communication chip is configured to transition from a low-power mode to a high-power mode, the transmission control module transmits the control signal to control the transmission end to be connected to the ground resistor, and the first threshold is set based on receive sensitivity of the receive end. The embodiments of the present disclosure reduce the influence of the consistency of devices such as the antenna, the matching network, and the near field communication chip on the received voltage at the receive end, thereby improving the performance consistency of the near field communication apparatus serving as the card simulator.

### BRIEF DESCRIPTION OF DRAWINGS

To more clearly describe technical solutions of embodiments of the present disclosure or the prior art, drawings to be used in the description of the embodiments or the prior art will be briefly introduced below. Apparently, the drawings in the description below are merely some embodiments disclosed in the embodiments of the present disclosure. For those of ordinary skills in the art, other drawings may also be obtained based on these drawings.
FIG. 1 is a circuit diagram of a near field communication apparatus in an embodiment of the present disclosure;
FIG. 2 is a flowchart of a method for controlling a near field communication chip in an embodiment of the present disclosure;
FIG. 3 is a flowchart of a method for controlling a near field communication chip in another embodiment of the present disclosure; and
FIG. 4 is a flowchart of a method for controlling a near field communication chip in still another embodiment of the present disclosure.

### DETAILED DESCRIPTION

Technical solutions of embodiments of the present disclosure will be described below with reference to the drawings. For ease of description, in the embodiments of the present disclosure, same reference numerals denote same components, and for the sake of brevity, detailed descriptions of same components are omitted in different embodiments.

It should be noted that the embodiments in the present disclosure and/or the technical features in the embodiments may be combined with each other in any way in case of no conflict, and the combined technical solutions should also fall into the scope of protection of the present disclosure.

It should be understood that the specific examples in the embodiments of the present disclosure are provided only to help those skilled in the art to better understand the embodiments of the present disclosure, rather than limiting the scope of the embodiments of the present disclosure.

It should be further understood that in the embodiments of the present disclosure, the magnitudes of the sequence numbers of the processes do not mean the execution sequence. The execution sequence of the processes should be determined based on functions and internal logics thereof, and should not impose any limitation on the implementation processes of the embodiments of the present disclosure.

It should be understood that the terms used in the embodiments and the appended claims of the present disclosure are intended merely to describe particular embodiments, and are not intended to limit the embodiments of the present disclosure. For example, the singular forms of "a" and "the" used in the embodiments and the appended claims of the present disclosure are also intended to include plural forms, unless the context explicitly indicates other meanings.

As used herein, the terms such as "first," "second," and "third" describe various components, elements, regions, layers, and/or sections, but such components, elements, regions, layers, and/or sections should not be limited by such terms. Such terms are only used to distinguish one component, element, region, layer, or section from another. The terms such as "first," "second," and "third" when used herein do not imply a sequence or order unless otherwise explicitly indicated by the context.

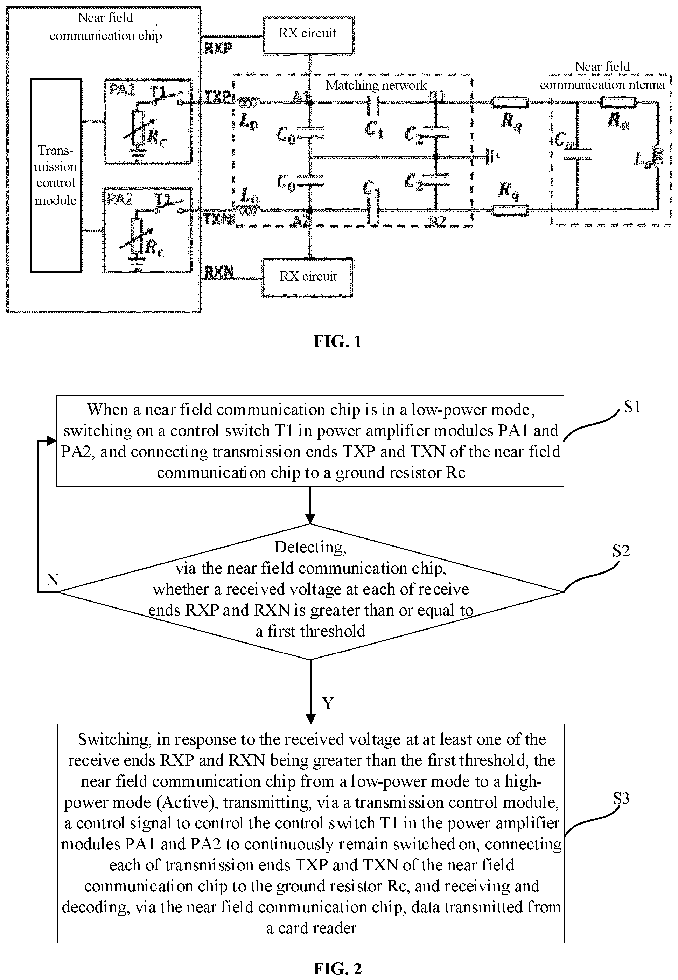

Ordinary near field communication chips are classified into differential and single-ended forms depending on application scenario requirements. A differential near field communication chip comprises a first transmission end and a second transmission end, namely, TXP and TXN, a single-ended near field communication chip may comprise only one transmission end, namely, TXP or TXN, or the first transmission end TXP and the second transmission end TXN may be connected to form a connection end. Referring to FIG. 1, an ordinary differential near field communication apparatus comprises: a matching network and two RX circuits (receiving circuits). The near field communication chip is connected to a near field communication antenna through the matching network. An RX circuit is connected between each of receive ends RXP and RXN of the near field communication chip and the matching network. The matching network comprises: two first inductors L0, two first capacitors C0, two second capacitors C1, and two third capacitors C2. In addition, for the single-ended near field communication chip, the near field communication apparatus comprises a matching network and an RX circuit (receiving circuit). The matching network comprises: a first inductor L0, a first capacitor C0, a second capacitor C1, and a third capacitor C2. A second inductor La, a seventh capacitor Ca, and a first resistor Ra in FIG. 1 are equivalent lumped circuit devices of the near field communication antenna. The matching network is configured to match the near field communication antenna to a target resistance value at an operating frequency of the equivalent circuit composed of the matching network and the near field communication antenna.

In order to improve the performance consistency of the near field communication apparatus, referring to FIG. 2, an embodiment of the present disclosure provides a near field communication chip for use in the near field communication apparatus serving as a card simulator.

The differential near field communication chip comprises: two transmission ends TXP and TXN, two receive ends RXP and RXN, two power amplifier modules PA1 and PA2, and a transmission control module. The two power amplifier modules PA1 and PA2 are connected between the two transmission ends TXP and TXN and the transmission control module respectively.

The single-ended near field communication chip comprises: a transmission end TXP or TXN, a receive end RXP or RXN, and a power amplifier module PA1 or PA2, wherein the power amplifier module PA1 or PA2 is connected between the transmission end TXP or TXN and the transmission control module.

For ease of description, the embodiments of the present disclosure are introduced only with the differential near field communication chip as an example.

Referring to FIG. 1, each of the power amplifier modules PA1 and PA2 comprises a ground resistor Rc and a control switch T1 in series, one end of the control switch T1 is connected to the transmission end TXP or TXN, and the other end of the control switch is connected to the ground resistor Rc. The control switch T1 controls the transmission end to be connected to the ground resistor Rc or be floating based on a control signal transmitted from the transmission control module, and a resistance value of the ground resistor Rc is greater than or equal to 0.1 ohms and less than or equal to 10 ohms.

Specifically, each of the power amplifier modules PA1 and PA2 further comprises circuit elements such as a power supply and a clock, which will not be repeated in the embodiments of the present disclosure.

In order to simplify the circuit design, those skilled in the art may implement the ground resistor Rc and/or control switch T1 in the embodiments of the present disclosure as transistors.

In a specific implementation of an embodiment of the present disclosure, the near field communication chip is used in the near field communication apparatus serving as a card emulator. Referring to FIG. 2, a method for controlling a near field communication chip includes:

Step S1: when the near field communication chip is in a low-power mode (standby), switching on a control switch T1 in power amplifier modules PA1 and PA2, and connecting transmission ends TXP and TXN of the near field communication chip to a ground resistor Rc.

Step S2: detecting, via the near field communication chip, whether a received voltage at each of receive ends RXP and RXN is greater than or equal to a first threshold.

Specifically, the first threshold is set based on receive sensitivity of the receive ends RXP and RXN.

Step S3: switching, in response to the received voltage at at least one of the receive ends RXP and RXN being greater than or equal to the first threshold, the near field communication chip from a low-power mode to a high-power mode (Active), transmitting, via a transmission control module, a control signal to control the control switch T1 in the power amplifier modules PA1 and PA2 to continuously remain switched on, connecting each of transmission ends TXP and TXN of the near field communication chip to the ground resistor Rc, and receiving and decoding, via the near field communication chip, data transmitted from a card reader.

The near field communication chip transitions from the low-power mode to the high-power mode (known as wake-up). If the transmission ends TXP and TXN are floating or are connected to a resistor with a large resistance, the received voltage is greatly affected by the consistency of devices such as the antenna, the matching network, and the near field communication chip, thereby further resulting in great inconsistency in the wake-up performance of the near field communication apparatus. When the near field communication chip receives and decodes the data from the card reader, if the transmission ends TXP and TXN are floating or are connected to a resistor with a large resistance, the received voltage is greatly affected by the consistency of devices such as the antenna, the matching network, and the near field communication chip, thereby further resulting in great inconsistency in the decoding performance of the near field communication apparatus.

In an embodiment of the present disclosure, assuming that when the near field communication chip is in the low-power mode, the power amplifier modules PA1 and PA2 may configure the control switch T1 thereof to be switched on, and the transmission ends TXP and TXN of the near field communication chip are connected to the ground resistor Rc. In an embodiment of the present disclosure, when the near field communication chip transitions from the low-power mode to the high-power mode and decodes the data received from the card reader, the transmission ends TXP and TXN are connected to the ground resistor Rc, and a resistance value of the ground resistor Rc is greater than or equal to 0.1 ohms and less than or equal to 10 ohms, thereby reducing the influence of the inconsistency of devices such as the antenna, the matching network, and the near field communication chip on the received voltage, and improving the consistency of the near field communication apparatus.

If the received voltage at each of the receive ends RXP and RXN is less than the first threshold, the step S1 is returned to after preset time.

The preset time is set by those skilled in the art as needed.

Specifically, the near field communication chip periodically detects the received voltages of the receive ends RXP and RXN, thereby accurately detecting the received voltages of the receive ends RXP and RXN.

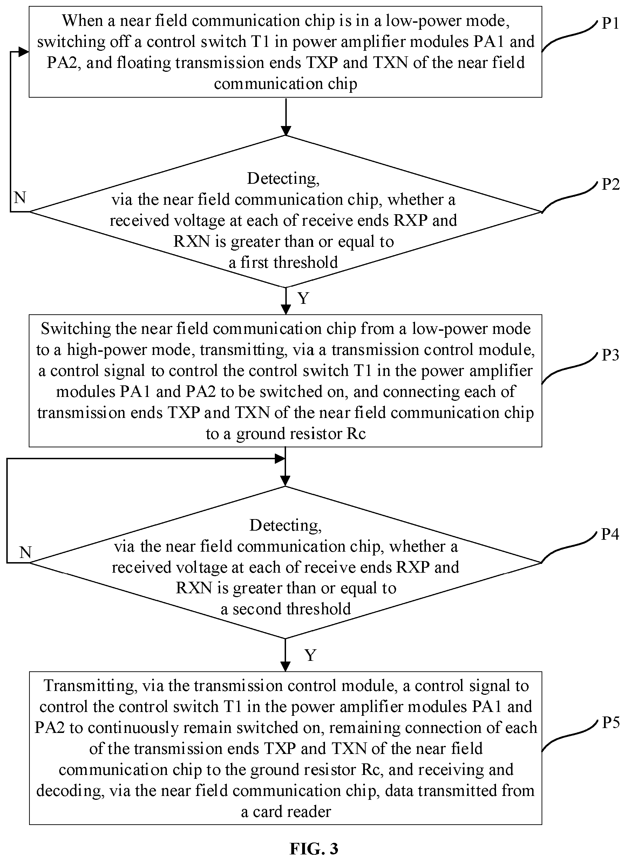

In another specific implementation of an embodiment of the present disclosure, the near field communication chip is used in the near field communication apparatus serving as a card simulator. Referring to FIG. 3, a method for controlling a near field communication chip includes:
Step P1: when the near field communication chip is in a low-power mode, switching off a control switch T1 in power amplifier modules PA1 and PA2, and floating transmission ends TXP and TXN of the near field communication chip.
Step P2: detecting, via the near field communication chip, whether a received voltage at each of receive ends RXP and RXN is greater than or equal to a first threshold.

Specifically, the first threshold is set based on receive sensitivity of the receive ends RXP and RXN.

Step P3: switching, in response to the received voltage at at least one of the receive ends RXP and RXN being greater than or equal to the first threshold, the near field communication chip from a low-power mode to a high-power mode, transmitting, via a transmission control module, a control signal to control the control switch T1 in the power amplifier modules PA1 and PA2 to be switched on, and connecting each of transmission ends TXP and TXN of the near field communication chip to a ground resistor Rc.

Step P4: when the near field communication chip is in the high-power mode, and each of the transmission ends TXP and TXN is connected to the ground resistor Rc, further determining whether the received voltage at each of the receive ends RXP and RXN detected by the near field communication chip is greater than or equal to a second threshold.

Specifically, the second threshold is set based on receive sensitivity of the receive ends RXP and RXN.

In a specific implementation of an embodiment of the present disclosure, the first threshold and the second threshold have the following relationship: if the received voltage at the at least one receive end RXP or RXN when the at least one transmission end TXP or TXN is connected to the ground resistor Rc is greater than the received voltage at the at least one receive end RXP or RXN when the at least one transmission end TXP or TXN is floating, the second threshold is greater than the first threshold, and otherwise, the second threshold is greater than, less than, or equal to the first threshold.

Step P5: transmitting, via the transmission control module in response to the received voltage at the at least one of the receive ends RXP and RXN being greater than or equal to the second threshold, a control signal to control the control switch T1 in the power amplifier modules PA1 and PA2 to continuously remain switched on, connecting each of the transmission ends TXP and TXN of the near field communication chip to the ground resistor Rc, and receiving and decoding, via the near field communication chip, data transmitted from a card reader.

The near field communication chip transitions from the low-power mode to the high-power mode (known as wake-up). If the transmission ends TXP and TXN are floating or are connected to a resistor with a large resistance, the received voltage is greatly affected by the consistency of devices such as the antenna, the matching network, and the near field communication chip, thereby further resulting in great inconsistency in the wake-up performance of the near field communication apparatus. When the near field communication chip receives and decodes the data from the card reader, if the transmission ends TXP and TXN are floating or are connected to a resistor with a large resistance, the received voltage is greatly affected by the consistency of devices such as the antenna, the matching network, and the near field communication chip, thereby further resulting in great inconsistency in the decoding performance of the near field communication apparatus.

In an embodiment of the present disclosure, assuming that when the near field communication chip is in the low-power mode, the power amplifier modules PA1 and PA2 fail to configure the control switch T1 thereof to be switched on, and the transmission ends TXP and TXN of the near field communication chip fail to be connected to the ground resistor Rc. In an embodiment of the present disclosure, when the near field communication chip transitions from the low-power mode to the high-power mode and decodes the data received from the card reader, the transmission ends TXP and TXN are connected to the ground resistor Rc, and a resistance value of the ground resistor Rc is greater than or equal to 0.1 ohms and less than or equal to 10 ohms, thereby reducing the influence of the inconsistency of devices such as the antenna, the matching network, and the near field communication chip on the received voltage, and improving the consistency of the near field communication apparatus.

In addition, in an embodiment of the present disclosure, if the near field communication chip is in the low-power mode, and the transmission ends TXP and TXN of the near field communication chip fail to be set to connect the ground resistor Rc, it is necessary to determine the received voltages of the receive ends RXP and RXN twice.

If the received voltage at each of the receive ends RXP and RXN is less than the first threshold, the step P1 is returned to after preset time. The preset time is set by those skilled in the art as needed.

In an embodiment of the present disclosure, if the received voltage at each of the receive ends RXP and RXN is less than the first threshold, the low-power mode is remained to detect whether the received voltage at each of the receive ends RXP and RXN is greater than the first threshold.

If the received voltage at each of the receive ends RXP and RXN is less than the second threshold, the step P4 is returned to after preset time. The preset time is set by those skilled in the art as needed.

In an embodiment of the present disclosure, if the received voltage at each of the receive ends RXP and RXN is less than the second threshold, the high-power mode is remained to detect whether the received voltage at each of the receive ends RXP and RXN is greater than the second threshold.

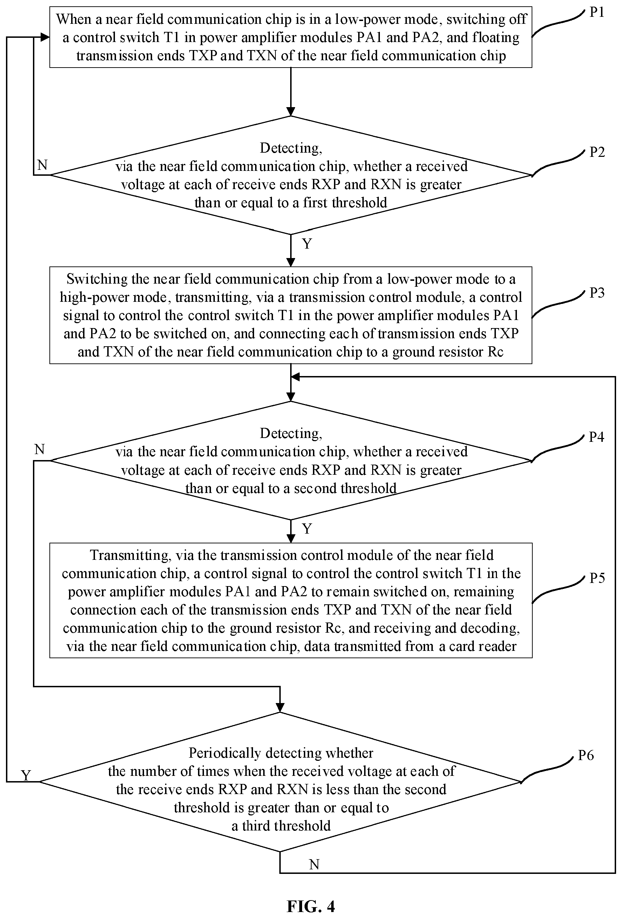

Referring to FIG. 4, the control method in an embodiment of the present disclosure further includes:
Step P6: periodically detecting, via the receive ends RXP and RXN, the received voltage, and returning to the step P1 after preset time, in response to the number of times when the received voltage at each of the receive ends RXP and RXN is less than the second threshold being greater than or equal to a third threshold. The preset time is set by those skilled in the art as needed.

In an embodiment of the present disclosure, if the number of times when the received voltage at each of the receive ends RXP and RXN is less than the second threshold is greater than or equal to the third threshold, the low-power mode is retained to detect whether the received voltage at each of the receive ends RXP and RXN is greater than the first threshold.

Specifically, the third threshold is set based on power consumption requirements of the near field communication chip. If low power consumption is desired, a smaller third threshold may be set; and if high power consumption is tolerable, a larger third threshold may be set.

If the number of times when the received voltage at each of the receive ends RXP and RXN is less than the second threshold is less than the third threshold, the step P4 is returned to after the preset time. The preset time is set by those skilled in the art as needed.

The embodiments of the present disclosure reduce the influence of the consistency of devices such as the antenna, the matching network, and the near field communication chip on the received voltage at the receive end, thereby improving the performance consistency of the near field communication apparatus serving as the card simulator.

Referring to FIG. 1, an embodiment of the present disclosure further provides a near field communication apparatus, comprising the near field communication chip in any one of the above embodiments, a matching network, and a near field communication antenna, wherein one end of the matching network is connected to the near field communication chip, and the other end of the matching network is connected to the near field communication antenna.

An embodiment of the present disclosure further provides a near field communication electronic device, comprising the near field communication apparatus in any one of the above embodiments.

The embodiments of the present disclosure reduce the influence of the consistency of devices such as the antenna, the matching network, and the near field communication chip on the received voltage at the receive end, thereby improving the performance consistency of the near field communication apparatus serving as the card simulator.

It should be noted that, depending on the implementation requirements, the components/steps described in the embodiments of the present disclosure may be split into more components/steps, or two or more components/steps or partial operations of the components/steps may be combined into novel components/steps to achieve the goal of the embodiments of the present disclosure.

As will be appreciated by those of ordinary skills in the art, the various example units and method steps described in combination with the embodiments disclosed herein can be implemented by electronic hardware, or a combination of computer software and electronic hardware. Whether these functions are executed by hardware or software depends on particular applications and design constraints of the technical solutions. Those skilled in the art may implement the described functions for each particular application using different methods, but such implementation should not be considered as falling beyond the scope of the embodiments of the present disclosure.

The above embodiments are only used to illustrate the embodiments of the present disclosure, and are not intended to limit the embodiments of the present disclosure. Those of ordinary skills in the relevant technical field may further make various alterations and modifications without departing from the spirit and scope of the embodiments of the present disclosure. Therefore, all equivalent technical solutions are also encompassed within the scope of the embodiments of the present disclosure, and the scope of patent protection of the embodiments of the present disclosure should be defined by the claims.

## Claims

1. A near field communication chip, for use in a near field communication apparatus serving as a card emulator and comprising: a transmission end, a receive end, a power amplifier module, and a transmission control module, wherein the power amplifier module is connected between the transmission end and the transmission control module;
the power amplifier module comprises a ground resistor and a control switch, wherein one end of the control switch is connected to the transmission end, the other end of the control switch is connected to the ground resistor, the control switch is configured to control the transmission end to be connected to the ground resistor or be floating based on a control signal transmitted from the transmission control module, and a resistance value of the ground resistor is greater than or equal to 0.1 ohms and less than or equal to 10 ohms; and
when a received voltage at the receive end is greater than or equal to a first threshold, the near field communication chip is configured to transition from a low-power mode to a high-power mode, the transmission control module transmits the control signal to control the transmission end to be connected to the ground resistor, and the first threshold is set based on receive sensitivity of the receive end.

2. The near field communication chip according to claim 1, wherein
when the near field communication chip is a single-ended form, the near field communication chip comprises the transmission end, the receive end, and the power amplifier module, and the power amplifier module is connected between the transmission end and the transmission control module; and
when the near field communication chip is a differential form, the near field communication chip comprises two transmission ends, two receive ends, and two power amplifier modules, and the two power amplifier modules are connected between the two transmission ends and the transmission control module respectively.

3. The near field communication chip according to claim 2, wherein
When the near field communication chip is in the low-power mode, and the transmission end is connected to the ground resistor , in response to a received voltage at at least one of the receive ends being greater than or equal to the first threshold, the near field communication chip is configured to transition from the low-power mode to the high-power mode, the transmission control module transmits the control signal to control the transmission end to remain connected to the ground resistor, and the near field communication chip is configured to receive and decode data transmitted from a card reader.

4. The near field communication chip according to claim 2, wherein
when the near field communication chip is in the low-power mode and the transmission end is floating, in response to a received voltage at at least one of the receive end being greater than or equal to the first threshold, the near field communication chip is configured to transition from the low-power mode to the high-power mode, and the transmission control module transmits the control signal to control the transmission end to be connected to the ground resistor; and
when the near field communication chip is in the high-power mode and the transmission end is connected to the ground resistor, the transmission control module transmits, in response to the received voltage at the at least one receive end being greater than or equal to a second threshold, the control signal to control the transmission end to remain connected to the ground resistor, and the near field communication chip is configured to receive and decode data transmitted from a card reader, wherein the second threshold is set based on sensitivity of the receive ends.

5. The near field communication chip according to claim 3 or 4, wherein
in response to the received voltage at the receive ends being less than the first threshold, the near field communication chip is configured to return to the low-power mode in which the near field communication chip is configured to continuously detect whether the received voltage at the receive ends is greater than or equal to the first threshold; or
in response to the received voltage at the receive ends being less than the fourth threshold, the near field communication chip is configured to return to the low-power mode in which the near field communication chip is configured to continuously detect whether the received voltage at the receive ends is greater than or equal to the fourth threshold, the fourth threshold is greater than or equal to the first threshold.

6. The near field communication chip according to claim 4, wherein
when the near field communication chip is in the high-power mode and the transmission end is connected to the ground resistor, the near field communication chip is configured to retain in the high-power mode in response to the received voltage at the receive ends being less than the second threshold, wherein the near field communication chip is configured to continuously detect whether the received voltage at the at least one receive ends is greater than or equal to the second threshold in the high-power mode.

7. The near field communication chip according to claim 6, wherein
the receive end periodically detects the received voltage, and returns to the low-power mode in response to the number of times when the received voltage at the receive ends is less than the second threshold being greater than or equal to a third threshold, wherein the near field communication chip is configured to continuously detect whether the received voltage at the at least one receive end is greater than or equal to the first threshold in the low-power mode; and
the third threshold is set based on standby power consumption of the near field communication chip.

8. The near field communication chip according to claim 1, wherein the ground resistor and/or the control switch are implemented using transistors.

9. A near field communication antenna apparatus, comprising the near field communication chip according to any one of claims 1-8, a matching network, and a near field communication antenna, wherein one end of the matching network is connected to the near field communication chip, and the other end of the matching network is connected to the near field communication antenna.

10. A near field communication electronic device, comprising the near field communication chip according to any one of claims 1-9, a matching network, and a near field communication antenna, wherein one end of the matching network is connected to the near field communication chip, and the other end of the matching network is connected to the near field communication antenna.

11. A method for controlling near field communication, for use in a near field communication apparatus serving as a card emulator, a near field communication chip comprising: a transmission end, a receive end, a power amplifier module, and a transmission control module, wherein the power amplifier module is connected between the transmission end and the transmission control module; the power amplifier module comprises a ground resistor and a control switch, one end of the control switch is connected to the transmission end, the other end of the control switch is connected to the ground resistor, the control switch is configured to control the transmission end to be connected to the ground resistor or be floating based on a control signal transmitted from the transmission control module, and a resistance value of the ground resistor is greater than or equal to 0.1 ohms and less than or equal to 10 ohms; and
the control method comprising:
detecting whether a received voltage at the receive end is greater than or equal to a first threshold; and
switching, in response to the received voltage at the receive end being greater than or equal to the first threshold, the near field communication chip from a low-power mode to a high-power mode, transmitting, via the transmission control module, the control signal to control the transmission end to be connected to the ground resistor, and setting the first threshold based on receive sensitivity of the receive end.

12. The method according to claim 11, wherein
when the near field communication chip is in the low-power mode and the transmission end is connected to the ground resistor, the switching, in response to the received voltage at the receive end being greater than or equal to the first threshold, the near field communication chip from the low-power mode to the high-power mode, and transmitting, via the transmission control module, the control signal to control the transmission end to be connected to the ground resistor comprises:
switching, in response to the received voltage at at least one of the receive end being greater than or equal to the first threshold, the near field communication chip from the low-power mode to the high-power mode, transmitting, via the transmission control module, the control signal to control the transmission end to remain connected to the ground resistor, and receiving and decoding, via the near field communication chip, data transmitted from a card reader.

13. The method according to claim 11, wherein
when the near field communication chip is in the low-power mode and the transmission end is floating, the switching, in response to the received voltage at the receive end being greater than or equal to the first threshold, the near field communication chip from the low-power mode to the high-power mode, and transmitting, via the transmission control module, the control signal to control the transmission end to be connected to the ground resistor comprises:
switching, in response to a received voltage at at least one of the receive end being greater than or equal to the first threshold, the near field communication chip from the low-power mode to the high-power mode, and transmitting, via the transmission control module, the control signal to control the transmission end to be connected to the ground resistor; and
when the near field communication chip is in the high-power mode and the transmission end is connected to the ground resistor, transmitting, via the transmission control module in response to the received voltage at the at least one receive end being greater than or equal to a second threshold, the control signal to control the transmission end to remain connected to the ground resistor, receiving and decoding, via the near field communication chip, data transmitted from a card reader; and setting the second threshold based on sensitivity of the receive end.

14. The method according to claim 12 or 13, wherein the method further comprises:
returning, in response to the received voltage at the receive ends being less than the first threshold, the near field communication chip to the low-power mode in which the near field communication chip is configured to continuously detect whether the received voltage at the at least one receive end is greater than or equal to the first threshold.

15. The method according to claim 13, wherein the method further comprises:
when the near field communication chip in the high-power mode, connecting the transmission end to the ground resistor, retaining, in response to the received voltage at the receive end being less than the second threshold, the near field communication chip in the high-power mode in which the near field communication chip is configured to continuously detect whether the received voltage at the at least one receive end is greater than or equal to the second threshold; or
periodically detecting, via the receive ends, the received voltage, and returning to the low-power mode in response to the number of times when the received voltage at the receive end is less than the second threshold being greater than or equal to a third threshold, wherein the near field communication chip is configured to continuously detect whether the received voltage at the at least one receive end is greater than or equal to the first threshold in the low-power mode; and
setting the third threshold based on standby power consumption of the near field communication chip.
